# EUROPEAN PATENT SPECIFICATION

(11) **EP 0 237 220 B1**
(45) Date of publication and mention of the grant of the patent: **01.12.1993**
(21) Application number: 87301539.0
(22) Date of filing: 23.02.1987
(51) Int. Cl.: H01J 37/317, H01J 37/32, G03F 1/00, H01J 37/305

(54) **Method and apparatus for forming a film**
Verfahren und Gerät zur Filmherstellung
Méthode et appareil pour former un film

(30) Priority: 24.02.1986 JP 38628/86
(43) Date of publication of application: 16.09.1987
(73) Proprietor: SEIKO INSTRUMENTS INC., Tokyo 136 (JP)
(72) Inventor: Kaito, Takashi, Koto-ku Tokyo (JP)
(74) Representative: Miller, Joseph

(56) References cited:
- EP-A- 0 075 949
- PATENT ABSTRACTS OF JAPAN, vol. 9, no. 19 (E-292)[1742], 25th January 1985 & JP-A-59 168 652
- EXTENDED ABSTRACTS OF THE 16TH (1984 INTERNATIONAL) CONFERENCE ON SOLID STATE DEVICES AND MATERIALS, Kobe, 1984, pages 31-34, Tokyo, JP; K. GAMO et al.: "Characteristics of selective deposition of metal organic films using focused ion beams"
- PATENT ABSTRACTS OF JAPAN, vol. 9, no. 193 (E-334)[1916], 9th August 1985 & JP-A-60 59 738 (MATSUSHITA DENSHI KOGYO K.K.) 06-04-1985
- PROC. 9th SYMP. on ISIAT '85, TOKYO, JP (1985), p. 657 - 664

## Description

A method of repairing a mask by the ion beam CVD method has been proposed in Proc. 9th Symp. on ISIAT 1985, pp 657-664. As disclosed therein, the method comprises irradiating a specific portion of a substrate on which a film is to be formed, the irradiation being effected with a focused ion beam, and spraying a vapour stream of a polymerisable or carbonisable organic compound at and around the area being irradiated with the focused ion beam to thereby polymerise or carbonise the organic compound at said specific portion to form a desired film thereon. Also it is possible to form an electrically conductive film by using a vapour of metallisable compound in the above method.

White-spot defects in a mask appear to be completely repaired by the above-mentioned method, as far as one can judge from an observation of the light-transmitting properties and of the defects in the mask. However, by copying the mask pattern by means of an exposure device, it is clear that the opaque film which has been formed has fringes at its sides which restrict the conditions in which the mask can be used.

To explain this in detail, as a result of inspection by means of reflected light, and an analysis of the secondary ion mass and the like, it can be proved that extremely thin fringes (e.g. the order of several tens of Å) whose quality is the same as that of the light shielding film formed for the repair occur at the sides of the repaired portion where the opaque film is formed. The fringes of the film reflect and absorb light, so that the light-transmitting properties of the regions covered by the fringes are somewhat reduced, thus restricting the conditions in which the mask can be used.

Moreover, when an electrically conductive pattern film is formed on a semiconductive device such as an IC by the above-mentioned method, the film sometimes shows electrical defects due to the fringes of the film.

A method of forming such a film can be found in extended abstracts of the 16th (1984 International) Conference on Solid State Devices and Materials, Kobe, 1984, Tokyo, JP, p.31-34; K. Gamo et al.:"Characteristics of selective deposition of metal organics films using focused ion beams".

According, therefore, to the present invention, there is provided a method of forming a film on a specific portion of a substrate comprising irradiating the said specific portion with a focused ion beam, and directing onto the said specific portion material which will be caused by the focused ion beam to form the said film, the latter having a fringe on at least one side thereof, characterised in that the or each said fringe is then selectively removed.

Preferably a vapour stream of a polymerisable, carbonisable or metallisable organic compound is directed onto the said specific portion.

Thus in one form of the present invention, a light-shielding film or an electrically conductive film is formed on the substrate by means of an ion beam assisted CVD method, and, in addition, the fringes of the film formed at the sides of the previously made light-shielding film or at the sides of the electrically conductive film are removed, e.g. by reactive plasma etching or the like.

Light -shielding films may be formed on the white-spot defects of the mask, or electrically conductive films may be formed on a semi-conductive device by means of the ion beam CVD method. After the films have been formed on the substrate, the fringes of the film at the sides of the light-shielding film or at the sides of the electrically conductive film are removed by selectively removing them, e.g. by reactive plasma etching. Consequently, the white-spot defects or electrical defects can be completely repaired so as to make a mask of high quality.

The removal of the or each said fringe may be effected not only by a reactive plasma etching process as indicated above but also by an oxygen gas plasma etching process or by oxidising and gasifying the fringes by ozone. The ozone may be generated as a result of ultraviolet irradiation.

An apparatus for forming a film on a specific portion of a substrate comprises irradiating means for irradiating the said specific portion with a focused ion beam, material directing means for directing onto the said specific portion material which in operation will be caused by the focused ion beam to form the said film together with a fringe on at least one side of the film, and fringe removal means for selectively removing the or each said fringe.

Scanning means may be provided for deflecting the ion beam over the surface of the substrate.

There may be a secondary charged particles detector for detecting the secondary charged particles emitted from the surface of the substrate, and a display for showing an image generated by the said detected secondary charged particles.

There may be a scanning area establishing unit for using the said image to locate the said specific portion.

The material directing means may comprise a gas gun for spraying compound gas onto the surface of the substrate.

The fringe removal means may comprise an enclosure which is arranged to receive the substrate on which the said film has been formed, the said enclosure being arranged to communicate with a main chamber within which the film is, in operation, formed on the substrate, and means for transferring the substrate between the main chamber and the said enclosure.

The said enclosure may be provided with means for evacuating it and with means for generating a plasma.

The invention is illustrated, merely by way of example, in the accompanying drawings, in which:-
Figure 1 is a block diagram showing an apparatus for repairing a mask;
Figure 2(a) shows a fringed film formed on a photomask by the ion beam CVD method; and
Figure 2(b) shows the said film after its fringes have been removed by oxygen plasma etching.

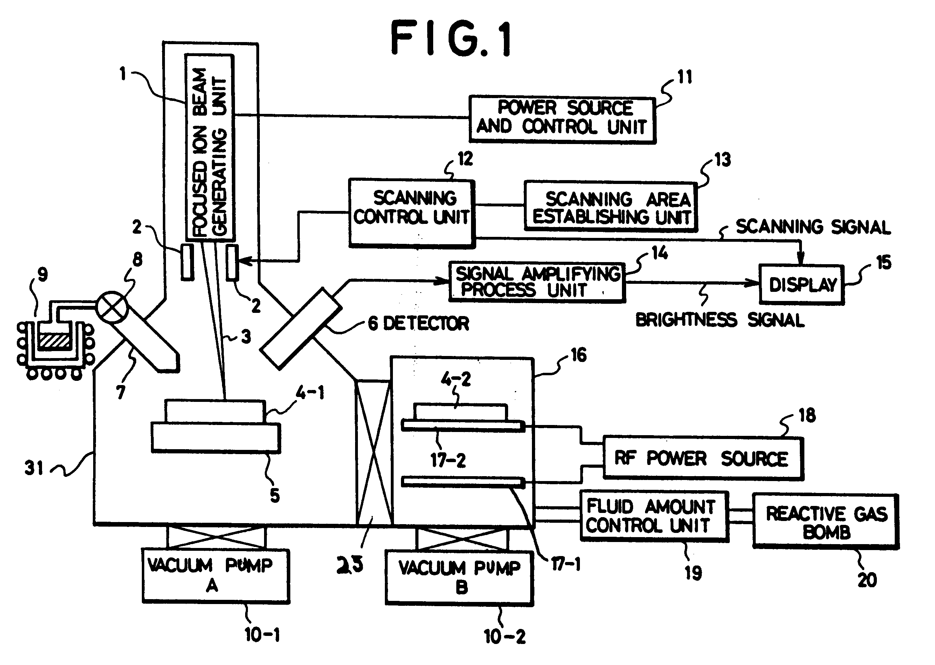

Referring to Figure 1, a gas source 9 contains a compound for spraying a compound gas onto a substrate. A vacuum pump 10-1 is connected to a main chamber 31 and a vacuum pump 10-2 is connected to a preparatory discharge and plasma process enclosure 16. The enclosure 16 is adapted to communicate with the main chamber 31 by way of a gate valve 23 which may be opened and closed.

A focused ion beam 3 generated by a focused ion beam generating unit 1 is irradiated onto a specific portion of a mask 4-1 which is to be repaired, the mask 4-1 being supported on an X-Y stage 5. The focused ion beam 3 is scanned over the mask 4-1 in the X and Y directions by deflecting electrodes 2. A power source and control unit 11 control the operation of the focused ion beam generating unit 1.

The secondary electrons or the like, which are emitted from the surface of the mask 4-1, are detected by a detector 6, are amplified and processed by a signal amplifying process unit 14, and are shown on a display 15 as a SIM image or the like. The position of the mask 4-1 observed on the display 15 changes because instructions from a sample movement control unit (not shown) drive the X-Y stage 5. As above stated, the mechanism and method of this invention make it possible to observe the SIM image of the mask 4-1 and to determine exactly the positions of the defects to be repaired. In the above manner, the X-Y stage 5 is moved so that the portions of the defects to be repaired can be indicated on the display 15 as a SIM image. Next, the area of scanning is determined by a scanning area establishing unit 13 so that only the portion of the defects shown on the display 15 can be repeatedly scanned a number of predetermined times. A valve 8 of a gas gun 7 opens by means of starting signals for the repair of the white-spot defects. Then, pyrene (C₁₆H₁₀) gas, as an example, is blown from the gas source 9 onto the said specific portion of the surface of the mask 4-1. At the same time, the focused ion beam 3, the scanning of which is controlled by the scanning area establishing unit 13 by way of a scanning control unit 12, irradiates the white-spot defects of the mask 4-1 and dissolves the absorbed pyrene gas so as to make a hard carbon film. The carbon film has excellent light-shielding and adhesion properties.

It achieves the specified strength of light-shielding at about 2,000 Angstroms in thickness. As stated above, light-shielding films are formed in the white-spot defects. In this state, however, a fringe whose thickness may amount to several tens of Angstroms, (the material being hard carbon) is formed at the sides of the light-shielding film. Thus, the contrast of the mask is lowered, so that the exposure conditions of the mask are restricted. Accordingly, after all the defects of the mask 4-1 are completely repaired, the following treatment is given in order to remove the fringes of the film.

The mask 4-1, all of whose defects have been completely repaired, is transferred (by means not shown) from the X-Y stage 5 onto a stage and electrode 17-1 in the preparatory discharge and plasma process enclosure 16. A mask 4-2, which is to be subsequently repaired, is transferred from a stage and electrode 17-2 in the enclosure 16 onto the X-Y stage 5 after the gate valve 23 has been opened. When the transference of the mask 4-2 is completed, the gate valve 23 for dividing the preparatory discharge and plasma process enclosure 16 from the main chamber 31 which contains the X-Y stage 5 is closed. Oxygen gas is then introduced from a reactive gas bomb 20 into the preparatory discharge and plasma process enclosure 16 by a fluid amount control unit 19 so that the gas pressure within the enclosure 16 becomes appropriate. In addition, by operating an R-F power source 18, RF voltage is applied between the stage and electrode 17-1 and the stage and electrode 17-2 so as to generate oxygen plasma, and the mask 4-1, which has been transferred onto the stage and electrode 17-1, is given oxygen plasma etching for a specified period of time. Then, the pressure within the preparatory discharge and plasma process enclosure 16 is returned to atmospheric pressure, and by opening the front door (not shown) of the enclosure 16, the mask 4-1, which has been completely repaired, is taken out. Further, the mask to be repaired next is placed on the stage and electrode 17-2, and the discharge of the preparatory discharge and plasma process enclosure 16 is started. The above mentioned procedures enable a mask to be rapidly repaired and permit the manufacture of a mask of high quality.

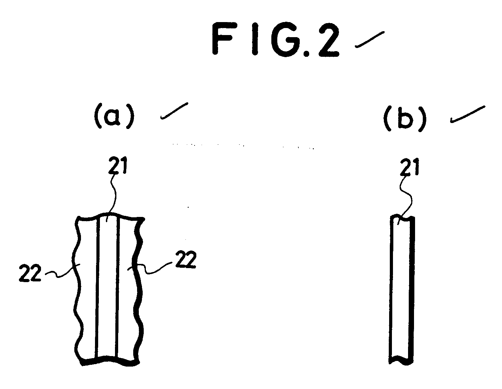

The method of mask repairing and the effect of the device of the present invention will now be explained in particular by referring to Figure 2. Figures 2(a)(b) are photographs made by a metallographical microscope by means of reflected light in order to show the effect of the present invention. Figure 2(a) shows a film formed by the known ion beam assisted CVD method. The reference numeral 21 indicates a film (a hard carbon film) of about 2,000 Angstroms in thickness. The reference numeral 22 indicates the fringes attached at the sides of the film 21, the thickness of the fringes 22 being several tens of Angstroms. The known method and device gives rise to such fringes.

Figure 2(b) shows a film which has received reactive plasma etching after a hard carbon film has been formed. It is obvious from the latter photograph that the fringes at the sides of the film have been removed. Needless to say, the method and apparatus of the present invention also make it possible to repair black-spot defects easily by scanning an ion beam instead of blowing gas by means of a gas gun.

As particularly stated in the above explanation, the defects of the mask can be completely repaired and a mask of high quality can be obtained by the method of the present invention.

In the process according to the present invention described above, the fringes of the film are selectively removed after the films have been formed by an ion beam assisted CVD method. As a result, the contrast of the repaired portion of the mask is lowered and, therefore, a mask of high quality can be obtained. Since the process of selectively removing the fringes may be effected by reactive plasma etching, the fringes of the film can be removed without damaging the mask.

It has been proved that a hard carbon film meets the strength of adhesion, the degree of light-shielding and the other conditions required for a repaired film. It has also been proved by an experiment that the fringes of the film made at the time of forming the hard carbon film can be selectively removed by oxygen plasma etching. (Refer to Figure 2(b)).

The fringes of a hard carbon film can also be removed by the operation of ozone generated by ultraviolet irradiation.

The above description concerns the repair of a mask. However, a fringe of an electrically conductive pattern which has been formed on a semiconductive substrate by the CVD method using a scanning focused ion beam, can be completely removed by reactive plasma etching.

## Claims

1. A method of forming a film (21) on a specific portion of a substrate (4-1) comprising irradiating the said specific portion with a focused ion beam (3), and directing onto the said specific portion material which will be caused by the focused ion beam (3) to form the said film (21), the latter having a fringe (22) on at least one side thereof, characterised in that the or each said fringe (22) is then selectively removed.

2. A method as claimed in claim 1 characterised in that a vapour stream of a polymerisable, carbonisable or metallisable organic compound is directed onto the said specific portion.

3. A method as claimed in claim 1 or 2 characterised in that the removal of the or each said fringe (22) is effected by means of a reactive plasma etching process.

4. A method as claimed in claim 1 or 2 characterised in that the removal of the or each said fringe (22) is effected by means of an oxygen gas plasma etching process.

5. A method as claimed in claim 1 or 2 characterised in that the removal of the or each said fringe (22) is effected by oxidising and gasifying the fringes by ozone.

6. A method as claimed in claim 5 characterised in that the ozone is generated as a result of ultraviolet irradiation.

## Patentansprüche

1. Verfahren zur Bildung eines Films (21) auf einem spezifischen Teil eines Substrats (4-1), bei dem der spezifische Teil mit einem fokussierten Ionenstrahl (3) bestrahlt wird und der Ionenstrahl auf das Material des spezifischen Teils gerichtet wird, das durch den Ionenstrahl (3) zur Bildung des Films (21) veranlaßt wird, der auf wenigstens einer seiner Seiten einen Rand (22) besitzt, **dadurch gekennzeichnet**, daß der oder jeder Rand (22) dann selektiv entfernt wird.

2. Verfahren nach Anspruch 1, **dadurch gekennzeichnet**, daß ein Dampfstrom einer polymerisierbaren, karbonisierbaren oder metallisierbaren organischen Verbindung auf den spezifischen Teil gerichtet wird.

3. Verfahren nach Anspruch 1 oder 2, **dadurch gekennzeichnet**, daß die Entfernung des oder jedes Randes (22) mittels eines reaktiven Plasmaätzprozesses erfolgt.

4. Verfahren nach Anspruch 1 oder 2, **dadurch gekennzeichnet**, daß die Entfernung des oder jedes Randes (22) mittels eines Sauerstoffgas-Plasmaätzprozesses erfolgt.

5. Verfahren nach Anspruch 1 oder 2, **dadurch gekennzeichnet**, daß die Entfernung des oder jedes Randes (22) durch Oxidieren und Vergasen der Ränder durch Ozon erfolgt.

6. Verfahren nach Anspruch 5, **dadurch gekennzeichnet**, daß das Ozon als Ergebnis einer Ultraviolettstrahlung erzeugt wird.

## Revendications

1. Un procédé de formation d'un film (21) sur une partie spécifique d'un substrat (4-1) comprenant des étapes consistant à: soumettre à un rayonnement de ladite partie spécifique à l'aide d'un faisceau ionique focalisé (3), et le diriger sur ladite matière de partie spécifique qui sera amenée par le faisceau ionique focalisé (3) à former ledit film (21), ce dernier comportant une frange (22) sur au moins l'un de ses côtés, caractérisé en ce que ladite frange (22) ou chacune d'elle est ensuite enlevée sélectivement.

2. Procédé selon la revendication 1 caractérisé an ce qu'un courant de vapeur d'un composé organique susceptible d'être polymérisé, carbonisé ou métallisé est dirigé sur ladite partie spécifique.

3. Procédé selon la revendication 1 ou 2 caractérisé en ce que l'enlèvement de ladite frange (22) ou de chacune d'elles est effectué au moyen d'un processus de gravure plasma réactive.

4. Procédé selon la revendication 1 ou 2 caractérisé en ce que l'enlèvement de ladite frange (22) ou de chacune d'elle est effectué au moyen d'un processus de gravure plasma à l'oxygène gazeux.

5. Procédé selon la revendication 1 ou 2 caractérisé en ce que l'enlèvement de ladite frange (22) ou de chacune d'elle est effectué en oxydant et en gazéifiant les franges à l'ozone.

6. Procédé salon la revendication 5 caractérisé en ce que l'ozone est engendrée comme résultat d'un rayonnement ultraviolet.
